Europäisches Patentamt

European Patent Office

Office européen des brevets

(19)

(11) Veröffentlichungsnummer: **0 073 949**
A2

(12) # EUROPÄISCHE PATENTANMELDUNG

(21) Anmeldenummer: 82107330.1

(22) Anmeldetag: 12.08.82

(51) Int. Cl.³: **C 23 C 13/06**

(30) Priorität: 29.06.82 DE 3224234
01.09.81 DE 3134589

(43) Veröffentlichungstag der Anmeldung:
16.03.83 Patentblatt 83/11

(84) Benannte Vertragsstaaten:
DE FR GB IT SE

(71) Anmelder: SIEMENS AKTIENGESELLSCHAFT
Berlin und München Wittelsbacherplatz 2
D-8000 München 2(DE)

(72) Erfinder: Neuwald, Anselm, Dipl.-Phys.
Gandershoferstrasse 25
D-8403 Bad Abbach(DE)

(54) Verfahren und Herstellung von metallfreien Streifen bei der Metallbedampfung eines Isolierstoffbandes und Vorrichtung zur Durchführung des Verfahrens.

(57) Das Verfahren zur Herstellung von metallfreien Streifen (18) bei der Metallbedampfung eines für den Einsatz in elektrischen Kondensatoren bestimmten Isolierstoffbandes (12) sieht vor, daß das zu metallisierende Isolierstoffband (12) und ein mit gleicher Geschwindigkeit mitlaufendes Abdeckband (13) zunächst in Kontakt gebracht werden, daß dann durch Aufdampfen von Öl ein Film (15) hergestellt wird, der auch die seitlichen Flächen (16) des Abdeckbandes (13) sowie geringfügig auch angrenzende Flächenbereiche (14) des Isolierstoffbandes (12) bedeckt. Die Vorrichtung für dieses Verfahren enthält eine Kühlwalze, einen Metallverdampfer, einen Ölverdampfer, der in Laufrichtung des Abdeckbandes vor dem Metallverdampfer angeordnet ist, Vorratsrollen für die zu metallisierenden Bänder und eine Reinigungsvorrichtung, die in Laufrichtung des Abdeckbandes vor dem Ölverdampfer angeordnet ist.

FIG 5

SIEMENS AKTIENGESELLSCHAFT
Berlin und München

0073949

Unser Zeichen
VPA 81 P 1121 E 01

Verfahren zur Herstellung von metallfreien Streifen bei der Metallbedampfung eines Isolierstoffbandes und Vorrichtung zur Durchführung des Verfahrens

Die Erfindung betrifft ein Verfahren zur Herstellung von metallfreien Streifen bei der Metallbedampfung eines Isolierstoffbandes, das für den Einsatz in elektrischen Kondensatoren bestimmt ist, bei dem das Isolierstoffband im Bereich der herzustellenden metallfreien Streifen durch ein endloses, am Isolierstoffband anliegendes und mit gleicher Geschwindigkeit mit diesem mitlaufenden Abdeckband abgedeckt wird, das vor dem Einlaufen in die Bedampfungszone auf der dem Metallbedampfer zugewandten Seite mit Öl beschichtet wird und das nach dem Durchlaufen der Bedampfungszone und nach dem Auseinanderführen des Abdeckbandes und des Isolierstoffbandes von aufgedampftem Metall durch Abstreifen befreit wird.

Die Erfindung betrifft ferner eine Vorrichtung zur Durchführung des Verfahrens, die eine Kühlwalze, einen Metallverdampfer, der in Laufrichtung des Abdeckbandes vor dem Metallverdampfer angeordnet ist, Vorratsrollen für die zu metallisierenden Bänder und eine Reinigungsvorrichtung enthält, die in Laufrichtung des Abdeckbandes vor dem Ölverdampfer angeordnet ist.

Ein derartiges Verfahren ist aus der US-PS 2 898 241 bekannt und auch im Prinzip die genannte Vorrichtung. Mit diesem bekannten Verfahren wird angestrebt, eine möglichst scharfkantige Begrenzung der auf dem Isolierstoffband aufgetragenen Metallschicht zu erreichen. Bei der Anwendung maskenartiger Blenden oberhalb des Metallver-

Bck 1 Dx / 28.06.1982

dampfers, die in einem größeren Abstand vom Isolierstoffband angeordnet sind, wird erreicht, daß die Ränder des Metallstreifens abnehmend zur Oberfläche des Isolierstoffbandes verlaufend entstehen. Wenn dieser allmähliche Übergang durch eine scharfkantige Begrenzung des Metallstreifens ersetzt werden soll, so wird bei dem bekannten Verfahren ein endloses Abdeckband, das für sich gegebenenfalls auch mit Wachs, Fett oder Öl versehen werden kann, in der Weise eingesetzt, daß dieses Band in direktem Kontakt mit dem Isolierstoffband und mit gleicher Geschwindigkeit mit demselben am Metallverdampfer vorbeiläuft. Nach Entfernen dieses Abdeckbandes entsteht die dort gewünschte scharfe Kante. Das in dieser Weise durchgeführte Abdecken der metallfreien Streifen führt nicht dazu, daß der Ölfilm auf dem Abdeckband geringfügig bis auf die Oberfläche des zu metallisierenden Isolierstoffbandes reicht. Insbesondere bei in diesem Zusammenhang als dick zu bezeichneten Metallschichten (entsprechend einer Leitfähigkeit bis zu 15 S) sind scharfe Kanten nachteilig, weil sie zu Durchschlägen im Kantenbereich zur Gegenbelegung führen; dies gilt besonders dann, wenn die Kondensatoren aus solchen metallisierten Isolierstoffbändern für Wechselstrom und Anwendung bei hohen Spannungen bestimmt sind.

In der DE-AS 26 52 438 sind ein Verfahren zur Herstellung von metallfreien Streifen bei der Metallbedampfung eines Isolierstoffbandes und im Prinzip auch eine Vorrichtung zur Durchführung dieses Verfahrens beschrieben, wobei sowohl Verfahren als auch Vorrichtung dem entsprechen, was in der US-PS 2 898 241 beschrieben ist. Es gelten somit für beide Fälle die gleichen Ausführungen.

Aus der DE-PS 12 62 732 ist außerdem die Methode bekannt, auf einem Isolierstoffband metallfreie Streifen dadurch herzustellen, daß die freizulassenden Teile des Bandes mit einem Abdeckmittel, wie z. B. Öl oder Fett, bedampft werden. Als geeignete Aufdampfstoffe sind dort Diffelen, Apiezonöl, Silikonöle angegeben.

Beide Verfahren sind beim Aufdampfen relativ dicker Metallschichten zur Herstellung von Freirändern wenig geeignet, da eine Ölabdeckung einen Metallniederschlag beim Aufdampfen dicker Schichten nicht mehr verhindern kann, während eine Bandabdeckung der genannten Art keine befriedigenden Ergebnisse mehr ergibt. Sofern eine zuzätzliche, am Träger anliegende Abdeckung verwendet wird, ergeben sich sogar an den Belägen scharfe Kanten, Grate und Ausbrüche, die zu einer Beschädigung des zu wickelnden Kondensators führen können.

Die Aufgabe, die der vorliegenden Erfindung zugrunde liegt, besteht in der Herstellung von sauber begrenzten metallfreien Streifen auf metallisierten Kunststoffolien mit nicht scharfkantigem Übergang der Metallbeläge zum metallfreien Streifen, wobei das Verfahren sowohl für die Herstellung dünner (etwa 1 S) als auch für die Herstellung dicker Aluminiumbeläge von beispielsweise 10 S bis 15 S Flächenleitfähigkeit einsatzfähig sein soll.

Es ist ferner Aufgabe der Erfindung, die bekannte Vorrichtung so zu verbessern, daß das Verfahren der Erfindung mit dieser Vorrichtung durchgeführt werden kann.

Zur Lösung dieser Aufgabe ist das Verfahren der eingangs angegebenen Art erfindungsgemäß dadurch gekennzeichnet, daß zunächst das zu metallisierende Isoliersoffband und das Abdeckband zusammen in Kontakt gebracht werden, daß dann durch Aufdampfen von Öl ein Film hergestellt wird, der auch die seitlichen Flächen des Abdeckbandes sowie geringfügig auch die angrenzenden Flächenbereiche des Isolierstoffbandes bedeckt, wonach die Metallbedampfung erfolgt.

Vorzugsweise besteht das mitlaufende endlose Abdeckband aus Polyimidfolie und weist eine Dicke von 0,1 bis 0,2 mm auf, weil ein solches Band einerseits eine ausreichende mechanische Festigkeit aufweist, um für längere Zeit verwendet zu werden und weil andererseits bei einer Dicke in dem angegebenen Bereich der Abschattungseffekt für den Öldampfstrom vernachlässigbar ist.

Der Ölfilm wird vorzugsweise in einer Breite aufgetragen, die die Breite des Abdeckbandes auf den angrenzenden Flächenbereich des Isolierstoffbandes je um 0,05 bis 0,2 mm überragt.

Die Breite der angrenzenden Flächenbereiche von je 0,05 bis 0,2 mm bewirkt, daß die Dicke des Ölfilmes, bedingt durch die Oberflächenspannung des Öles und durch die Streuwirkung des Ölstrahles, vom Abdeckband in einem für die spätere Metallschicht günstigem Bereich stetig abnehmend gegen Null verläuft.

Es ist ferner vorteilhaft, den Ölfilm in der Weise zu erzeugen, daß das Öl aus einer Düse verdampft wird, deren Abstand zur Oberfläche des Abdeckbandes 0,3 bis 0,5 mm beträgt.

Die Ölverdampferdüsen haben selbst praktisch rechteckige Querschnitte von einer Breite, die der Breite des Abdeckbandes entspricht. Durch die angegebene Größe des Abstandes zwischen Düse und Oberfläche des Abdeckbandes wird erreicht, daß der Öldampf sich gleichmäßig auf dem Abdeckband und in sich verringerndem Maße über den Rand desselben hinaus verteilt (Streuwirkung). Je nach Breite des Abdeckbandes können auch quer zur Laufrichtung desselben zwei und mehr Ölverdampferdüsen mit kleineren Öffnungsbreiten angeordnet sein.

Die Temperatur des Ölverdampfers beträgt vorzugsweise 200 ± 20 °C, insbesondere beim Aufdampfen von Diffelenöl. Die angegebene Temperatur des Ölverdampfers bewirkt, daß das zu bedampfende Isolierstoffband thermisch nicht überbelastet wird.

Das Verfahren der Erfindung hat den Vorteil, daß sich einerseits definiert begrenzte Metallisierungen ergeben, daß sich aber andererseits an den Rändern der Belagsflächen kein senkrecht nach oben gerichteter Grat bildet und daß ausgezackte Belagsränder vermieden werden. Der Metallbelag läßt sich von dem Abdeckband ohne Beschädigung dieses Bandes abstreifen, und beim erneuten Einlaufen in die Bedampfungszone können keine Metallreste auf die Isolierstoffolie gelangen. Um zunächst festhaftende Metallreste, die sich beim erneuten Durchlauf durch die Bedampfungszone lösen könnten, so weit wie möglich zu entfernen, ist es vorteilhaft und ausreichend, daß das aufgedampfte Metall unmittelbar nach Verlassen der Bedampfungszone und vor der neuerlichen Beschichtung mit Öl abgestreift wird. Dadurch wird verhindert, daß im Bereich von Umlenkwalzen, welche das Abdeckband in verschiedene Richtungen biegen, anhaftende Metallschichten gelockert werden und schließlich auf das zu bedampfende Isolierstoffband gelangen.

Die Erfindung hat weiterhin den Vorteil, daß das Abdeckband in den üblicherweise als Führungsmittel verwendeten Führungsnuten, die am Umfang von Führungsrollen angebracht sind, nach der Metallbedampfung nicht hochsteigt, was bei einer dicken Bedampfung ohne Ölabdeckung infolge der Verbreiterung des Bandes der Fall sein kann. Dadurch würde das Abdeckband aus seiner Richtung laufen.

Aus den genannten Gründen, nämlich wegen der Gefahr, daß gelockerte Metallschichten an dem Abdeckband verbleiben und auf das Isolierstoffband gelangen können, ist auch

die aus der DE-OS 15 21 588 bekannte Methode zur Lösung der Aufgabe nicht geeignet, nach der ein Abschirmband dadurch von niedergeschlagenem Metall befreit wird, daß es über eine Umlenkrolle geführt wird, wobei durch die Krümmung auf der Umlenkrolle die Metallschicht abplatzt.

Das Verfahren der Erfindung reduziert nicht nur den Niederschlag auf dem Abdeckband, sondern damit zusammenhängend auch dessen thermische Beanspruchung. Der Ölfilm, der die seitlichen Flächen des Abdeckbandes bedeckt, benetzt geringfügig auch die angrenzende Folienbahn und vermindert dadurch die Aluminiumablagerung in der Grenzzone vom Belag zum metallfreien Streifen, so daß die Ausbildung einer von der Bandoberfläche wegweisenden scharfen Belagskante unterbleibt. Damit ist verhindert, daß ausgezackte Belagskanten oder ein Grat an der Belagskante entstehen. Andererseits entfällt auch wegen der geringen Dicke des Ölfilmes eine unerwünschte Abschattung größerer Bezirke der kapazitiv wirksamen Fläche.

Zur Herstellung des Ölfilmes kann neben Diffelenöl auch Apiezonöl oder Silikonöl verwendet werden.

Die eingangs angegebene Vorrichtung zur Durchführung des Verfahrens ist zur Lösung der der Erfindung zugrunde liegenden Aufgabe erfindungsgemäß dadurch gekennzeichnet, daß in Laufrichtung der zu bedampfenden Isolierstoffbänder der Abstand zwischen der Düse des Ölverdampfers und der Mitte des Metallbedampfungsbereiches etwa 30 cm beträgt und daß der Abstand zwischen der Düse des Ölverdampfers und der Kühlwalze etwa 0,3 bis 0,6 mm beträgt.

Die Erfindung wird nachfolgend an Hand der Zeichnungen dem Stand der Technik gegenübergestellt und näher erläutert.

Es zeigen:

Fig. 1 ein mit Metallbelag und metallfreien Streifen versehenes Isolierstoffband gemäß Stand der Technik
im Querschnitt,

Fig. 2 ebenfalls ein mit Metallbelag und metallfreien
Streifen versehenes Isolierstoffband gemäß Stand
der Technik im Querschnitt,

Fig. 3 bis 6
die Herstellungsstufen des Verfahrens der
vorliegenden Erfindung und

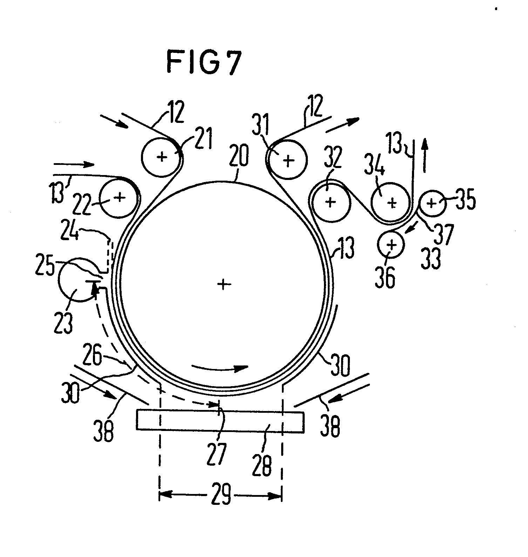

Fig. 7 die Vorrichtung zur Durchführung des Verfahrens
der Erfindung in ihrem prinzipiellen Aufbau.

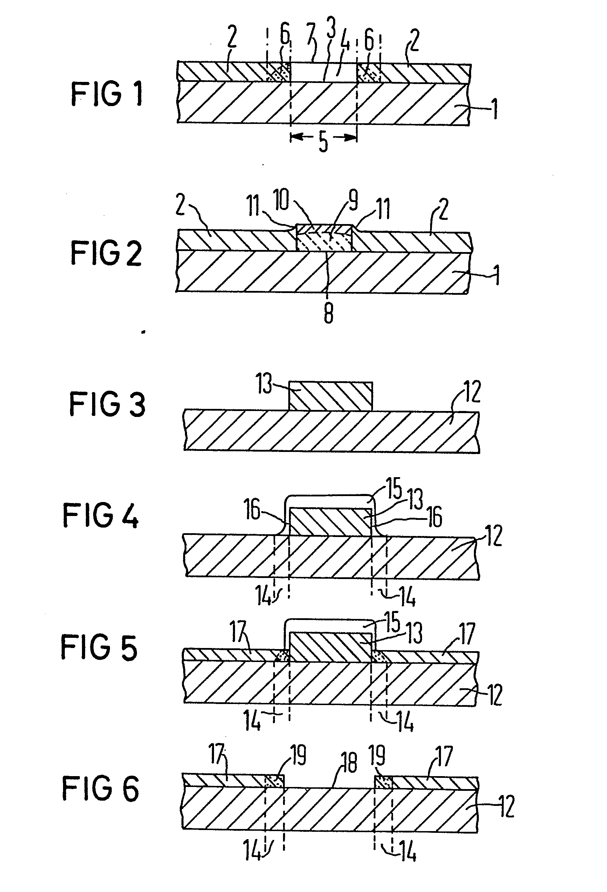

Fig. 1 zeigt ein Isolierstoffband 1, das gemäß Stand der
Technik (z. B. DE-PS 12 62 732) unter Verwendung einer
Ölabdeckung metallisiert ist. Die Metallbeläge 2, die -
wie auch bei der vorliegenden Erfindung - vorzugsweise
aus Aluminium oder legiertem Aluminium bestehen, sind
durch Metallbedampfung hergestellt. Der metallfreie
Streifen 3 entsteht durch die Ölabdeckung 4. Die Breite 5
des metallfreien Streifens 3 richtet sich nach der Breite
der Ölverdampferdüse. Zu beiden Seiten des metallfreien
Streifens 3 befindet sich je ein sogenannter "Graubereich" 6, der durch die vom Herstellungsverfahren bedingte, praktisch nicht beinflußbare Dickenabnahme der Ölabdeckung 4 entsteht.

Die Schwierigkeit, die bei dieser Art der Herstellung metallfreier Streifen bei der Metallbedampfung eines Isolierstoffbandes entsteht, besteht nun darin, daß auf der
Ölabdeckung 4 bei der Metallbedampfung ebenfalls Metallpartikel als Metallreste 7 entstehen. Da die als Ölstreifen vorliegende Ölabdeckung 4 nicht entfernt, sondern in
den herzustellenden Kondensator mitverwickelt wird, bilden diese Metallreste 7 unter Umständen Leitfähigkeitsbrücken zwischen den Metallbelägen 2. Ist z. B. der metallfreie Streifen 3 eine Trennung der beiden Metallbebeläge in einem Kondensator mit sogenannter innerer Reihenschaltung, bei der die Metallbeläge auf beiden Seiten des als Dielektrikum wirkenden Isolierstoffbandes versetzt angeordnet sind, so daß eine Hintereinanderschaltung von kapazitiv wirksamen Bereichen resultiert, dann wirken sich die Metallreste 7 nachteilig aus. Auch in dem Falle, in dem beim Zertrennen eines metallisierten Isolierstoffbandes zum Zwecke der Herstellung einzelner Kondensatorfolien diese Trennung in der Mitte des metallfreien Streifens 3 in Längsrichtung des Isolierstoffbandes erfolgt, wirken die Metallreste 7 dahingehend, daß Leitfähigkeitsbrücken zur Metallisierung gebildet werden können, die sich auf der nach dem Verwickeln des Kondentors entstehenden Stirnfläche befindet, obwohl dort, und zwar alternierend von Schicht zu Schicht, ein Kontakt schädlich ist.

In Fig. 2 ist das Isolierstoffband ebenfalls mit 1 bezeichnet, weil es auch gemäß Stand der Technik metallisiert ist, beispielsweise gemäß dem Verfahren, das in der US-PS 2 898 241 beschrieben ist. Die Metallbeläge 2, die auch hier durch Metallaufdampfung hergestellt sind, lassen einen Streifen 8 metallfrei, der durch das mit dem Isolierstoffband mitlaufende Abdeckband 9 (hier links gestrichelt gezeichnet) entstanden ist. Bei dieser Ausführungsform führt der Aluminiumniederschlag zu einem starken Anwachsen der Aluminiumschicht 10 auf der oberen Fläche des Abdeckbandes 9 und auch an den Längsseiten desselben, so daß das Bandmaterial sowohl des Abdeckbandes als auch des zu metallisierenden Isolierstoffbandes thermisch hoch belastet wird. Beim Lauf eines solchen durch Aluminiumaufwachsung verbreiterten Bandes durch die notwendigerweise mit enger Toleranz gefertigten Nuten der Führungsrollen an der Bedampfungsvorrichtung hebt sich das Band auf einer Seite vom Nutgrund ab und steigt an der Flanke empor. Dies bedeutet eine Änderung der Lage des metallfreien Streifens zwischen den herzustellenden Aluminiumbelegungen 2. Durch das Hochsteigen und die thermische Belastung dehnt sich das Abdeckband 9 aus, wowodurch schließlich der Verlauf des Bandes vollständig verändert wird, so daß der metallfreie Streifen an unerwünschten Stellen entsteht; es kommt sogar bis zum Abriß des Abdeckbandes. Mit zunehmendem Anwachsen der Aluminiumschicht 10 auf dem Abdeckband 9 lösen sich immer häufiger Aluminiumteile ab und gelangen in den aus dem metallisierten Isolierstoffband hergestellten Wickel. Bei der Weiterverarbeitung des metallisierten Isolierstoffbandes zum Zwecke der Herstellung von Einzelkondensatoren führt diese Verschmutzung teilweise zu beträchtlichen Schwierigkeiten. Nicht zuletzt ist die Grenzzone zwischen Belag 2 und metallfreien Streifen 8 als scharfe, praktisch senkrecht nach oben gerichtete Kante 11 aus Metall ausgebildet. Derartig scharfe Kanten führen im Kondensatorwickel zu Fehlstellen.

Bei dem Verfahren gemäß der vorliegenden Erfindung (vergleiche Fig. 3 bis 6) wird das zu metallisierende Isolierstoffband 12 zunächst mit dem Abdeckband 13 zusammengeführt. Isolierstoffband 12 und Abdeckband 13 gelangen dann mit gleicher Geschwindigkeit miteinander in den Bereich der Ölaufdampfung, wo sowohl das Abdeckband 13 als auch die beidseitig angrenzenden Flächenbereiche 14 des Isolierstoffbandes mit einem Ölfilm 15 versehen werden. Die Flächen 16 an der Längsseite des Abdeckbandes 13 sind ebenfalls von dem Ölfilm umschlossen. Danach gelangt das Isolierstoffband 12 zusammen mit dem Abdeckband 13 und dem Ölfilm 15 in den Bereich des Metallbedampfers, wo die Metallbeläge 17 entstehen. Diese Metallbeläge können aus Aluminium, aus legiertem Aluminium oder aus jedem anderen aufdampfbaren Metall hergestellt werden.

Im Bereich der angrenzenden Flächenbereiche 14 nimmt die Dicke des Ölfilmes kontinuierlich bis zum Wert Null ab. Dementsprechend entsteht in diesen Flächenbereichen eine vom Metallbelag 17 zum Abdeckband 13 in ihrer Dicke abnehmende Metallschicht, die mit Öl durchsetzt ist und den Kantenbereich 19 der Metallbeläge 17 bildet.

Nach dem Entfernen des Abdeckbandes 13 samt dem auf ihm befindlichen Ölfilm 15 und den auch darauf abgeschiedenen Metallpartikeln entsteht ein metallfreier Streifen 18, der von jeglichen Resten an Metallpartikeln frei ist.

Die "Graubereiche" (so bezeichnet, weil bei Durchleuchtung der metallisierten Folie der Übergangsbereich 14 grau erscheint, ebenso, wie ein grauer Bereich zu sehen ist, wenn auf den metallfreien Streifen bis über die Randbereiche hinaus transparentes Klebeband gedrückt und wieder abgezogen wird) in den an den metallfreien Streifen 18 angrenzenden Bereichen 14 sind hier in ähnlicher Weise vorhanden, wie es bei Fig. 1 erläutert ist. Jedoch ist die Breite dieser Bereiche definiert, es kommt durch das Verfahren der vorliegenden Erfindung nicht zur Ausbildung von Metallresten und die Kanten 19 der Metallbeläge 17 ragen aus der Ebene der Oberfläche der Metallbeläge 17 nicht heraus.

Somit verringert der Ölfilm in den Flächenbereichen 14 auf der Isolierstoffolie unmittelbar neben dem Abdeckband 13 die Ablagerung von Belagmetall auf das Isolierstoffband 12 während des Bedampfungsvorganges mit dem Ergebnis der Ausbildung der Kante im Übergangsbereich von Metallbelag 17 zu metallfreien Streifen 18 in der geschilderten Weise.

Durch den Ölfilm 15 wird die Haftung der Metallschicht auf dem Abdeckband 13 verringert. Dadurch läßt sich der Niederschlag in der Reinigungsvorrichtung vom Band besonders leicht entfernen, beispielsweise durch Abwischen mittels Filz. Das starke Anwachsen des Metalls (Aluminium) auf dem Abdeckband 13 entfällt und damit sämtliche Schwierigkeiten, die bei der Erläuterung der Fig. 2 dargelegt sind.

Nicht zuletzt ist der Niederschlag an Metall auf dem Abdeckband 13 reduziert, womit auch die thermische Belastung des Bandmaterials reduziert ist.

In Fig. 7 ist die Vorrichtung zur Durchführung des Verfahrens in ihrem prinzipiellen Aufbau gezeigt. Von einer Vorratsrolle (hier nicht gezeigt) gelangt das zu metallisierende Isolierstoffband über eine Umlenkrolle 21 auf die Oberfläche der Kühlwalze 20. Das endlose Abdeckband 13 gelangt über die Umlenkrolle 22 an den dafür vorgesehenen Stellen an das Isolierstoffband 12. Das Isolierstoffband 12 und das Abdeckband 13 gelangen gemeinsam mit gleicher Geschwindigkeit auf der Kühlwalze durch deren Rotation in den Bereich des Ölverdampfers 23. Der Abstand 24 der Düse 25 des Ölverdampfers 23 vom Abdeckband 13 beträgt vorzugsweise 0,3 bis 0,5 mm. Der Abstand 26 der Düse 25 des Ölverdampfers 23 und Mitte 27 des Metallbedampfungsbereiches 29 beträgt etwa 30 cm. In den Metallverdampfer 28 werden Drähte 38 aus dem zu verdampfenden Metall eingeleitet, wie es an sich bekannt ist.

Im Metallbedampfungsbereich 29 über dem Metallverdampfer 28 werden die Metallbeläge erzeugt. Der Metallbedampfungsbereich 29 ist von Abschirmteilen 30 begrenzt.

Kurz bevor das mit dem Metallbelag versehene Isolierstoffband 12 die Kühlwalze 20 an der Umlenkrolle 31 verläßt, wird das Abdeckband 13 über die Umlenkrolle 32 vom Isolierstoffband 12 abgehoben und zur Reinigungsstation (Reinigungsvorrichtung) 33 geleitet. Die Reinigungsvorrichtung 33 besteht aus einer Umlenkrolle 34, zwei Rollen 35 und 36 und einem Reinigungsband 37, das in gegenläufiger Richtung über das Abdeckband 13 geführt wird. Nach Verlassen der Reinigungsvorrichtung 33 wird (hier nicht gezeigt) das Abdeckband wieder der Umlenkrolle 22 zugeführt.

1 Bezugszeichenliste
6 Patentansprüche
1 Zusammenfassung
7 Figuren

Bezugszeichenliste

1   Isolierstoffband, metallisiert gemäß Stand der Technik

2   Metallbeläge (Al), hergestellt durch Metallbedampfung

3   Metallfreier Streifen, hergestellt durch Ölabdeckung

4   Ölabdeckung

5   Breite des metallfreien Streifens

6   Graubereich zu beiden Seiten des metallfreien Streifens 3

7   Metallreste auf Ölabdeckung 4

8   Metallfreie Streifen, hergestellt durch Bandabdeckung

9   Abdeckband

10  Metall auf dem Abdeckband

11  Scharfe Metallkante

12  Isolierstoffband, metallisiert gemäß Erfindung

13  Abdeckband

14  Angrenzende Flächenbereiche des Isolierstoffbandes

15  Ölfilm

16  Flächen an der Längsseite des Abdeckbandes 13

17  Metallbeläge

18  Metallfreier Streifen

19  Kantenbereich der Metallbeläge

20  Kühlwalze

21  Umlenkrolle

22  Umlenkrolle

23  Ölverdampfer

24  Abstand der Düse 25 vom Abdeckband 13

25  Düse des Ölverdampfers

26  Abstand der Düse 25 von der Mitte 27

27  Mitte des Metallbedampfungsbereiches 29

28  Metallverdampfer

29  Metallbedampfungsbereich (Bedampfungszone)

30  Abschirmteile

31  Umlenkrolle

32  Umlenkrolle

0073949

81 P 1 1 2 1 E 01

33 Reinigungsstation
34 Umlenkrolle
35 Rolle
36 Rolle
37 Reinigungsband
38 Drähte aus dem zu verdampfenden Metall

<u>Patentansprüche</u>

1. Verfahren zur Herstellung von metallfreien Streifen bei der Metallbedampfung eines Isolierstoffbandes, das für den Einsatz in elektrischen Kondensatoren bestimmt ist, bei dem das Isolierstoffband im Bereich der herzustellenden metallfreien Streifen durch ein endloses, am Isolierstoffband anliegendes und mit gleicher Geschwindigkeit mit diesem mitlaufenden Abdeckband abgedeckt wird, das vor dem Einlaufen in die Bedampfungszone auf der dem Metallbedampfer zugewandten Seite mit Öl beschichtet wird und das nach dem Durchlaufen der Bedampfungszone und nach dem Auseinanderführen des Abdeckbandes und des Isolierstoffbandes vom aufgedampftem Metall durch Abstreifen befreit wird, d a d u r c h   g e k e n n -  z e i c h n e t ,   daß zunächst das zu metallisierende Isolierstoffband (12) und das Abdeckband (13) zusammen in Kontakt gebracht werden, daß dann durch Aufdampfen von Öl ein Film (15) hergestellt wird, der auch die seitlichen Flächen (16) des Abdeckbandes (13) sowie geringfügig auch angrenzende Flächenbereiche (14) des Isolierstoffbandes (12) bedeckt, wonach die Metallbedampfung erfolgt.

2. Verfahren nach Anspruch 1, d a d u r c h   g e -  k e n n z e i c h n e t ,   daß ein mitlaufendes endloses Abdeckband (13) eingesetzt wird, das eine Dicke von 0,1 bis 0,2 mm aufweist.

3. Verfahren nach Anspruch 1 oder 2, d a d u r c h  g e k e n n z e i c h n e t ,   daß der Ölfilm in einer Breite aufgetragen wird, die die Breite des Abdeckbandes (13) auf den angrenzenden Flächenbereichen (14) je um 0,05 bis 0,2 mm überragt.

0073949

4. Verfahren nach einem der Ansprüche 1, 2 oder 3, d a d u r c h   g e k e n n z e i c h n e t , daß der Ölfilm (15) erzeugt wird, in dem das Öl aus einer Düse (25) verdampft wird, deren Abstand (24) zur Oberfläche des Abdeckbandes (13) 0,3 bis 0,5 mm beträgt.

5. Verfahren nach einem der Ansprüche 1 bis 4, d a - d u r c h   g e k e n n z e i c h n e t , daß die Temperatur des Ölverdampfers (23) 200 $\pm$ 20 °C beträgt, insbesondere beim Aufdampfen von Diffelenöl.

6. Vorrichtung zur Durchführung des Verfahrens nach einem der Ansprüche 1 bis 5, die eine Kühlwalze (20), einen Metallverdampfer (28), einen Ölverdampfer (23), der in Laufrichtung des Abdeckbandes (13) vor dem Metallverdampfer (28) angeordnet ist, Vorratsrollen für die zu metallisierenden Bänder und eine Reinigungsvorrichtung (33), die in Laufrichtung des Abdeckbandes (13) vor dem Ölverdampfer (23) angeordnet ist, enthält, d a d u r c h   g e k e n n z e i c h n e t , daß in Laufrichtung des zu bedampfenden Isolierstoffbandes (12) der Abstand (26) zwischen der Düse (25) des Ölverdampfers (23) und der Mitte (27) des Metallbedampfungsbereiches (29) etwa 30 cm beträgt und daß der Abstand (24) zwischen der Düse (25) des Ölverdampfers (23) und der Kühlwalze (20) etwa 0,3 bis 0,6 mm beträgt.

0073949

1/2

FIG 1

FIG 2

FIG 3

FIG 4

FIG 5

FIG 6

2/2

FIG 7